# EUROPEAN PATENT APPLICATION

(11) **EP 4 651 231 A1**
(43) Date of publication of application: **19.11.2025**
(21) Application number: 24841674.5
(22) Date of filing: 30.07.2024
(51) Int. Cl.: H01M 4/36, C23C 16/24, C23C 16/26, C23C 16/442

(54) **FLUIDIZED LARGE-SCALE PREPARATION METHOD FOR SILICON-CARBON NEGATIVE ELECTRODE MATERIAL**

(30) Priority: 03.04.2024 CN 202410399435
(71) Applicant: Suzhou Newmat Nanotechnology Co., Ltd., Suzhou, Jiangsu 215600 (CN)
(72) Inventor: QIAN, Zhen, Suzhou, Jiangsu 215600 (CN); HAN, Jing, Suzhou, Jiangsu 215600 (CN); LIU, Kai, Suzhou, Jiangsu 215600 (CN); LI, Weifeng, Suzhou, Jiangsu 215600 (CN)
(74) Representative: Acapo Onsagers AS
(86) International application number: PCT/CN2024/108550
(87) International publication number: WO 2025/208747

(57) **Abstract**

The present disclosure provides a fluidized large-scale preparation method for a silicon-carbon negative electrode material, relating to the technical field of battery materials, including: crushing a raw material, performing a fluidized silicon deposition reaction and a fluidized carbon deposition reaction. The fluidized silicon deposition reaction and the fluidized carbon deposition reaction are performed in a stirred fluidized bed reactor; and conditions of the stirred fluidized bed reactor include: a temperature of 300-1000 °C, and a stirring speed of 1-240 r/min. A silicon material and a carbon material are compounded using the stirred fluidized bed reactor, so as to realize large-scale preparation of the silicon-carbon negative electrode material, implement conductance modulation of materials, improve reaction activity and area of an electrode, shorten a lithium-ion diffusion distance, elevate a diffusion rate of lithium ions, and finally ameliorate cycle capacity, rate capability and the like of batteries.

## Description

### CROSS-REFERENCE TO RELATED APPLICATION

The present disclosure claims priority to the Chinese patent application with the filing No. 202410399435.1 filed with the Chinese Patent Office on April 3, 2024, and entitled "FLUIDIZED LARGE-SCALE PREPARATION METHOD FOR SILICON-CARBON NEGATIVE ELECTRODE MATERIAL", the contents of which are incorporated herein by reference in entirety.

### TECHNICAL FIELD

The present disclosure relates to the technical field of battery materials, and specifically to a fluidized large-scale preparation method for a silicon-carbon negative electrode material.

### BACKGROUND ART

In the dual carbon goals background, the new energy industry in China has been developed rapidly in recent years, and researching technologies of power batteries represented by lithium batteries or the like is an important issue of industrial development. Expeditious expansion of the battery market continuously sets up new heights for energy density and power density of power batteries. A silicon-based material system with a high theoretical specific capacity, as a negative electrode material, is considered as one of the most promising systems, and better matches future market development.

Negative electrode materials currently used in commercial lithium-ion batteries mainly include: graphite-based carbon materials, mainly artificial graphite and natural graphite; disordered carbon materials, including hard carbon and soft carbon; lithium titanate materials; and silicon-based materials, mainly including carbon-coated silicon monoxide composite materials, nano silicon-carbon composite materials, etc. Since the silicon-based negative electrode has a moderate lithiation potential, has no hazard of lithium deposition in the charging and lithiation process, and improves safety performance of the lithium-ion batteries, it is most promising to replace graphite as the next-generation of high-performance negative electrode material for lithium-ion batteries. However, lithiation of silicon has inherent disadvantages of large volume expansion (> 300%), poor electrical conductivity, and a low lithium ion diffusion coefficient, so that the silicon-based negative electrode materials have not achieved large-scale market application.

Silicon in silicon carbon and other silicon-based materials experiences a significant volume expansion during lithiation, and the stress generated in this process will cause the pulverization of electrode material and even fall-off from the current collector. Meanwhile, the electrolyte is continuously consumed due to its unceasing reaction with active materials, and it fails to form a stable solid electrolyte interface (SEI), ultimately leading to a degradation of material performance. Moreover, poor conductivity of silicon may also lead to severe electrode polarization, which in turn decreases the diffusion rate of lithium ions, and limits the output power of batteries.

In view of this, the present disclosure is specifically proposed.

### SUMMARY

Regarding the above shortcomings in the prior art, the present disclosure aims at providing a fluidized large-scale preparation method for a silicon-carbon negative electrode material. In the preparation method provided by examples of the present disclosure, a silicon material and a carbon material are compounded using a stirred fluidized bed reactor, so as to realize continuous large-scale preparation of the silicon-carbon negative electrode material, implement conductance modulation of materials, improve reaction activity and area of an electrode, shorten a lithium-ion diffusion distance, elevate a diffusion rate of lithium ions, and finally ameliorate cycle capacity, rate capability and the like of batteries.

In order to achieve the above objective, the examples of the present disclosure adopt the following technical solutions.

The present disclosure provides a fluidized large-scale preparation method for a silicon-carbon negative electrode material, including: crushing a raw material, performing a fluidized silicon deposition reaction and a fluidized carbon deposition reaction, wherein the fluidized silicon deposition reaction and the fluidized carbon deposition reaction are performed in a stirred fluidized bed reactor, and conditions of the stirred fluidized bed reactor include: a temperature of 300-1000 °C, and a stirring speed of 1-240 r/min.

In an optional embodiment, the method includes following steps:
step 1, crushing the raw material: performing crushing, grinding and sieving treatments on a porous carbon material to render a fine-grained porous carbon reaction raw material;
step 2, performing the fluidized silicon deposition reaction: performing silicon deposition on the fine-grained porous carbon reaction raw material obtained in step 1 in the stirred fluidized bed reactor into which a mixed gas of a carrier gas and a silicon source is introduced, to render a silicon-based intermediate; and
step 3, performing the fluidized carbon deposition reaction: performing carbon deposition on the silicon-based intermediate product obtained in step 2 into which a mixed gas of a carrier gas and a carbon source is introduced, to render the silicon-carbon negative electrode material.

In an optional embodiment, the fine-grained porous carbon reaction raw material has a particle size of 0-15 µm and not 0, and a specific surface area of 500-2500 m²/g.

In an optional embodiment, in step 2, a volumetric flow ratio of the silicon source to the carrier gas is 1:1-1:25; a deposition temperature is 400-800 °C, and time is 0.5-5 h; and a flow rate of the mixed gas in the reactor is 0.001-10 m/s.

In step 3, a volumetric flow ratio of the carbon source to the carrier gas is 1:1-1:40; a deposition temperature is 450-750 °C, and time is 1-6 h; and a flow rate of the mixed gas in the reactor is 0.001-10 m/s.

In an optional embodiment, the carbon source is at least one selected from the group consisting of C1-C10 alkane, C2-C10 alkene, C2-C10 alkyne and C6-C12 aromatic hydrocarbon.

Preferably, the carbon source is any one or more selected from the group consisting of methane, ethane, ethene, ethyne and propene.

In an optional embodiment, the silicon source includes any one or more of monosilane, disilane, hexamethyldisilane, chlorosilane and tetrafluorosilane.

In an optional embodiment, a mass ratio of the porous carbon to silicon in the silicon-based intermediate obtained in step 2 is 1-800.

In an optional embodiment, a percentage of a mass of deposited carbon of the silicon-carbon negative electrode material obtained in step 3 to a total mass is 0-30% and not 0.

In an optional embodiment, the stirred fluidized bed reactor is provided therein with a one-stage or multi-stage stirrer; and a stirring mode of the stirrer is any one or a combination of mechanical stirring, magnetic stirring, gas stirring and hydraulic stirring, preferably mechanical stirring or magnetic stirring.

In the above, the stirrer using the mechanical stirring mode is provided therein with a stirring paddle; an installation mode of the stirring paddle includes any one or a combination of vertical installation, horizontal installation, and inclined installation; and a structural form of the stirring paddle includes one or more of an anchor type, a paddle type, a turbine type, a propelling type and a frame type.

Due to use of the above technical solutions, the present disclosure has the following advantages compared with the prior art.

In the examples of the present disclosure, by performing the silicon deposition and carbon deposition in the stirred fluidized bed reactor, a preparation process is simple and reliable, and a process flow is short, which is conducive to scale-up production, and the obtained silicon-carbon negative electrode material has uniform carbon load, thereby achieving controllable adjustment of a silicon load amount and a carbon load amount.

The porous carbon raw material used in the present disclosure has a skeleton effect, effectively inhibits expansion of the silicon material, and further forms a load material through vapor deposition of a carbon deposition material having the advantages of high-strength toughness and high conductivity and a silicon material having a high specific capacity characteristic. Moreover, the present disclosure solves the problem of Li₁₅Si₄ phase of the existing silicon-carbon materials during the charging and discharging process and ensures the safe reliability and long-term stability of batteries on the basis of improving the specific capacity of batteries.

### BRIEF DESCRIPTION OF DRAWINGS

In order to more clearly illustrate the technical solutions of the examples of the present disclosure, drawings which need to be used in the examples will be briefly introduced below. It should be understood that the drawings merely show some examples of the present disclosure, and thus should not be considered as limitation to the scope. Those ordinarily skilled in the art still could obtain other relevant drawings according to these drawings, without using any inventive efforts.
FIG. 1 is a process flowchart of a preparation method for a silicon-carbon negative electrode material provided by the examples of the present disclosure;
FIG. 2 is a schematic view of a stirred fluidized bed reactor for fluidized silicon deposition reaction/carbon deposition reaction of the present disclosure;
FIG. 3 shows operation steps of the fluidized silicon deposition/fluidized carbon deposition reaction in the present disclosure; and
FIG. 4 is a schematic view of the fluidized silicon deposition reaction/fluidized carbon deposition reaction in different stirred fluidized bed reactors in the present disclosure.

### DETAILED DESCRIPTION OF EMBODIMENTS

In order to make the objectives, technical solutions and advantages of the examples of the present disclosure clearer, the technical solutions in the examples of the present disclosure will be described clearly and completely below. Examples, for which no concrete conditions are specified, are performed according to conventional conditions or conditions recommended by manufactures. Where manufacturers of reagents or apparatuses used are not specified, they are conventional products commercially available.

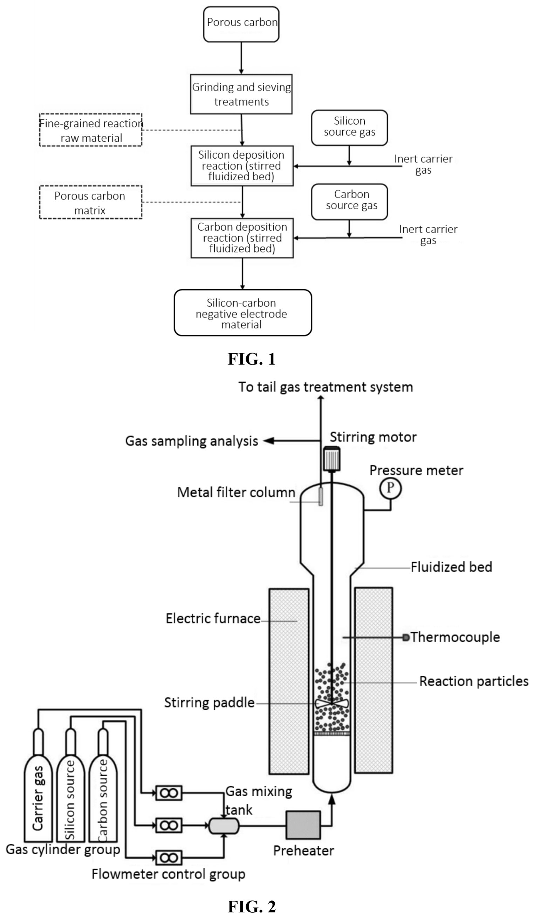

The present disclosure provides a fluidized large-scale preparation method for a silicon-carbon negative electrode material, with reference to FIG. 1, including:

### Step 1: crushing a raw material.

A porous carbon material is subjected to crushing, grinding and sieving treatments to render a fine-grained porous carbon reaction raw material, wherein the porous carbon material is prepared by the method described in the patent CN202310413886.1 Preparation Method for Porous Carbon and Multi-stage Fluidized Bed Reactor Thereof.

In order to ensure a pore structure of the porous carbon raw material to be well developed so that particles can be closely bonded after silicon deposition and carbon deposition reactions, the fine-grained porous carbon raw material has a particle size of 0-15 µm and not 0, preferably 3-8 µm, and a specific surface area of 500-2500 m²/g, preferably 1200-1800 m²/g.

### Step 2: performing a fluidized silicon deposition reaction.

The above fine-grained porous carbon reaction raw material is subjected to chemical vapor silicon deposition in a stirred fluidized bed reactor into which a mixed gas of a silicon source and a carrier gas is introduced, to render a silicon-based intermediate. The stirred fluidized bed reactor is used to improve a degree of uniformity of gas-solid contact, and optimize fluidization quality in the reactor.

Conditions of the stirred fluidized bed reactor include: a temperature of 300-1000 °C and a stirring speed of 1-240 r/min.

The stirred fluidized bed reactor is provided therein with a one-stage or multi-stage stirrer; and a stirring mode of the stirrer is any one or a combination of mechanical stirring, magnetic stirring, gas stirring and hydraulic stirring, preferably mechanical stirring or magnetic stirring.

In the above, the stirrer using the mechanical stirring mode is provided therein with a stirring paddle; an installation mode of the stirring paddle includes any one or a combination of vertical installation, horizontal installation, and inclined installation; and a structural form of the stirring paddle includes one or more of an anchor type, a paddle type, a turbine type, a propelling type and a frame type.

In order to ensure that silicon can be uniformly deposited in the porous carbon and ensure reasonable and controllable silicon deposition amount and deposition rate, a volumetric flow ratio of the silicon source to the carrier gas is 1:1-1:25, preferably 1:5-1:10; a deposition temperature is 400-800 °C, preferably 550-750 °C; time is 0.5-5 h, preferably 3-4 h; and a flow rate of the mixed gas in the reactor is 0.001-10 m/s, preferably 0.05-0.1 m/s.

The silicon source includes any one or more of monosilane, disilane, hexamethyldisilane, chlorosilane and tetrafluorosilane.

A mass ratio of the porous carbon to silicon in the silicon-based intermediate is 1-800, for example, preferably, 1-50.

### Step 3: performing a fluidized silicon deposition reaction.

A mixed gas of a carbon source and a carrier gas is introduced into the silicon-based intermediate to perform chemical vapor carbon deposition. In order to improve the deposition uniformity of carbon on particles and controllability of the deposition rate in a deposition process, a volumetric flow ratio of the carbon source to the carrier gas is 1:1-1:40, preferably 1:5-1:20; a deposition temperature is 450-750 °C, preferably 450-580 °C; a reaction time is 1-6 h, preferably 4-6 h; and a flow rate of the mixed gas in the reactor is 0.001-10 m/s, preferably 0.05-0.1 m/s.

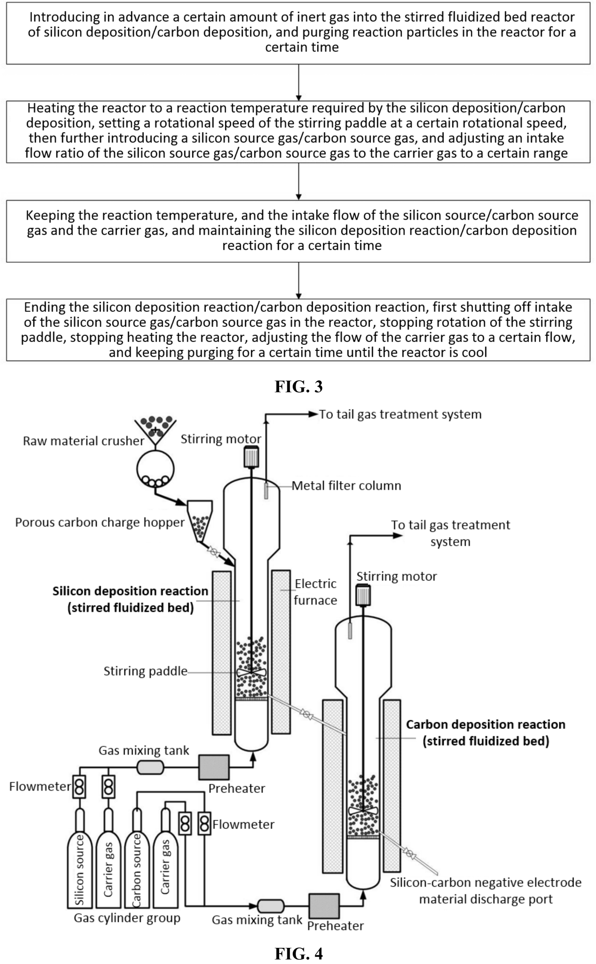

The carbon source is at least one selected from the group consisting of C1-C10 alkane, C2-C10 alkene, C2-C10 alkyne and C6-C12 aromatic hydrocarbon. Preferably, the carbon source is at least one selected from the group consisting of C1-C5 alkane, C2-C5 alkene or C2-C5 alkyne. For example, the carbon source is one or more selected from the group consisting of methane, ethylene, acetylene and propylene. In the above, the reactor and operation steps of the fluidized silicon deposition reaction/carbon deposition reaction in step 2 and step 3 are shown in FIG. 2 and FIG. 3, respectively.

The fluidized silicon deposition reaction and carbon deposition reaction in step 2 and step 3 may be performed in different stirred fluidized bed reactors (see FIG. 4) or the same stirred fluidized bed reactor.

An example of the present disclosure provides a fluidized large-scale preparation method for a silicon-carbon negative electrode material, in which a porous carbon with a high specific surface area and a fine particle size is used as a raw material, and a chemical vapor deposition method of silicon deposition and carbon deposition is used on a stirred fluidized bed reactor. A preparation process is simple and reliable and a process flow is short, which is conducive to scale-up production, and the obtained silicon-carbon negative electrode material has uniform silicon load, thereby achieving controllable adjustment of a silicon load amount and a carbon load amount.

It should be noted that the fluidization described in the examples of the present disclosure refers to a chemical reaction, such as chemical vapor deposition, by taking the fluidized bed as a reactor, and solid material particles are in a fluidized state during the reaction; large-scale preparation refers to large-scale industrial preparation of manufactured products, and the large-scale preparation can achieve a high yield on the premise of ensuring quality of products.

The porous carbon raw material used in the present disclosure has a skeleton effect, effectively inhibits expansion of the silicon material, and further forms a load material through vapor deposition of a carbon deposition material having the advantages of high-strength toughness and high conductivity and a silicon material having a high specific capacity characteristic. Moreover, the present disclosure solves the problem of Li₁₅Si₄ phase of the existing silicon-carbon materials during charging and discharging process, and ensures the safe reliability and long-term stability of batteries on the basis of improving the specific capacity of batteries.

Features and performances of the present disclosure are further described in detail below with reference to examples.

### Example 1

The present example provides a fluidized large-scale preparation method for a silicon-carbon negative electrode material, including:
performing crushing, grinding and sieving treatments on a porous carbon material (prepared with coconut shell carbon as a raw material with reference to patent CN202310413886.1), to render 100 kg of a fine-grained porous carbon reaction raw material with a particle size ranging from 0 µm to 15 µm (and being not 0); purging the fine-grained porous carbon reaction raw material in a stirred fluidized bed reactor for 0.5 h with introduction of argon as a carrier gas, heating the reactor to a temperature of 750 °C, starting a stirring paddle of the reactor, with a rotational speed being set to be 60 r/min, then performing silicon deposition for 2 h by taking monosilane as a silicon source gas, adjusting a volumetric flow ratio of monosilane gas to argon to be 1:10, and keeping a gas velocity in the fluidized bed reactor at 0.02 m/s, to render a silicon-based intermediate, and shutting off silane gas; and
keeping purging the reactor with argon, meanwhile adjusting the temperature of the reactor to 600 °C, introducing propylene as a carbon source gas, adjusting a volumetric flow ratio of propylene gas to argon to be 1:10, keeping the gas velocity in the fluidized bed reactor at 0.01 m/s, fluidizing the silicon-based intermediate obtained in the above step by a chemical vapor deposition method, and performing carbon deposition, with a reaction time being set at 4 h, shutting off the propylene gas, turning off heating of the reactor, and keeping purging the reactor with argon, until the reactor reaching a room temperature, thus rendering the silicon-carbon negative electrode material.

### Example 2

The present example provides a fluidized large-scale preparation method for a silicon-carbon negative electrode material. Operations of this preparation method are substantially consistent with that of Example 1, and merely differ in that: the reaction temperature of the fluidized silicon deposition was 550 °C, the reaction time was 4 h, the silicon source gas was chlorosilane, the volumetric flow ratio of chlorosilane gas to argon during the reaction was 1:25, and the gas velocity in the stirred fluidized bed reactor was kept at 0.015 m/s; the temperature of the reactor in the fluidized carbon deposition was 550 °C, and the reaction time was 3 h. Other steps are the same.

### Example 3

The present example provides a fluidized large-scale preparation method for a silicon-carbon negative electrode material. Operations of this preparation method are substantially consistent with that of Example 1, and merely differ in that: the rotational speed of the stirring paddle of the fluidized bed reactor was set to be 240 r/min, the carbon source gas was ethane, the volumetric flow ratio of ethane gas to argon was 1:15 in the fluidized carbon deposition reaction, the temperature of the reactor in the fluidized carbon deposition was 500 °C, the reaction time was 2 h, and the gas velocity in the stirred fluidized bed reactor was kept at 0.012 m/s. Other steps are the same.

### Example 4

The present example provides a fluidized large-scale preparation method for a silicon-carbon negative electrode material. Operations of this preparation method are substantially consistent with that of Example 1, and merely differ in that: the reaction temperature of the fluidized carbon deposition was 500 °C, the reaction time was 4 h, the silicon source gas was chlorosilane, the volumetric flow ratio of chlorosilane gas to argon was 1:5 in the reaction, the gas velocity in the stirred fluidized bed reactor was kept at 0.012 m/s; the carbon source gas was ethane, the volumetric flow ratio of ethane gas to argon was 1:8 in the fluidized carbon deposition reaction, the temperature of the reactor in the carbon deposition was 550 °C, the reaction time was 2 h, and the gas velocity in the stirred fluidized bed reactor was kept at 0.008 m/s. Other steps are the same.

### Example 5

The present example provides a fluidized large-scale preparation method for a silicon-carbon negative electrode material. Operations of this preparation method are substantially consistent with that of Example 1, and merely differ in that: the rotational speed of the stirring paddle of the reactor was set to be 30 r/min, chlorosilane acted as the silicon source gas, the volumetric flow ratio of chlorosilane gas to argon was 1:8; in the fluidized carbon deposition reaction, acetylene acted as the carbon source gas, the reaction temperature was 580 °C, the volumetric flow ratio of acetylene gas to argon was adjusted to be 1:40, the gas velocity in the stirred fluidized bed reactor was 0.015 m/s, and the reaction time was set to be 3.5 h. Other steps are the same.

### Example 6

The present example provides a fluidized large-scale preparation method for a silicon-carbon negative electrode material. Operations of this preparation method are substantially consistent with that of Example 1, and merely differ in that: the rotational speed of the stirring paddle of the reactor was set to be 10 r/min, and the gas velocity in the stirred fluidized bed reactor in both the fluidized silicon deposition reaction and fluidized carbon deposition reaction was 0.015 m/s. Other steps are the same.

### Comparative Example 1

The present comparative example provides a fluidized large-scale preparation method for a silicon-carbon negative electrode material. Operations of this preparation method are substantially the same as that in Example 1, and merely differ in that the particle size of the fine-grained porous carbon reaction raw material was 15-30 µm. Other steps are the same as those in Example 1.

### Comparative Example 2

The present comparative example provides a fluidized large-scale preparation method for a silicon-carbon negative electrode material. Operations of this preparation method are substantially consistent with that of Example 1, and merely differ in that: the fluidized silicon deposition reaction and the fluidized carbon deposition reaction used a fluidized bed reactor without a stirring function, once the silicon source gas or carbon source gas started to be introduced, particles in the fluidized bed reactor started to be fluidized, and during the fluidized silicon deposition reaction, the volumetric flow ratio of silane gas to argon was adjusted to be 1:15, the gas velocity in the fluidized bed reactor was kept at 0.05 m/s; during the fluidized carbon deposition reaction, the volumetric flow ratio of propylene gas to argon was adjusted to be 1:5, and the gas velocity in the fluidized bed reactor was kept at 0.008 m/s. All of other steps are the same as those in Example 1, and will not be repeated herein.

### Comparative Example 3

The present comparative example provides a fluidized large-scale preparation method for a silicon-carbon negative electrode material. Operations of this preparation method are substantially the same as that in Example 1, and merely differ in that:

the fluidized silicon deposition reaction was performed in a fluidized bed reactor without a stirring function, and when argon was introduced to purge prior to the silicon deposition reaction, the gas velocity in the bed was set to be 0.02 m/s, so that the particles in the fluidized bed reactor were in a fluidized state; when the reactor was heated to a temperature of 450 °C, the volumetric flow ratio of silane gas to argon was adjusted to be 1:12, and the gas velocity in the fluidized bed reactor was kept at 0.04 m/s; while the fluidized carbon deposition reaction was performed in a stirred fluidized bed reactor, the rotational speed of the stirring paddle was set to be 120 r/min, when the argon was introduced to purge prior to the carbon deposition reaction, the gas velocity in the bed was set to be 0.02 m/s, and the particles in the stirred fluidized bed reactor were kept in a fluidized state in a process of heating the reactor to 800 °C; and in the fluidized carbon deposition reaction, acetylene acted as a carbon source gas, and the volumetric flow ratio of propylene gas to argon was adjusted to be 1:8, and the gas velocity in the fluidized bed reactor was kept at 0.011 m/s. Other steps are the same as those in Example 1, and will not be repeated herein.

### Comparative Example 4

The present comparative example provides a fluidized large-scale preparation method for a silicon-carbon negative electrode material. Operations of this preparation method are substantially the same as that in Example 1, and merely differ in that:
the fluidized silicon deposition reaction was performed in a stirred fluidized bed reactor, the rotational speed of the stirring paddle was set to be 150 r/min, chlorosilane acted as a silicon source gas in the silicon deposition reaction, the volumetric flow ratio of chlorosilane gas to argon was adjusted to be 1:8, and the gas velocity in the fluidized bed reactor was kept at 0.015 m/s; the fluidized carbon deposition reaction was performed in a fluidized bed reactor without a stirring function, ethane acted as a carbon source gas in the carbon deposition reaction, the volumetric flow ratio of ethane gas to argon was adjusted to be 1:15, and the gas velocity in the fluidized bed reactor was kept at 0.03 m/s. Other steps are the same as those in Example 1, and will not be repeated herein.

### Comparative Example 5

The present comparative example provides a fluidized large-scale preparation method for a silicon-carbon negative electrode material. Operations of this preparation method are substantially the same as that in Example 1, and merely differ in that: the reaction temperature of the fluidized silicon deposition was 350 °C, the reaction time was 8 h, the silicon source gas was chlorosilane, the volumetric flow ratio of argon to chlorosilane gas was 1:10, and the gas velocity in the stirred fluidized bed reactor was kept at 0.015 m/s. Other steps are the same as those in Example 1.

### Comparative Example 6

The present comparative example provides a fluidized large-scale preparation method for a silicon-carbon negative electrode material. Operations of this preparation method are substantially the same as that in Example 1, and merely differ in that: the reaction temperature of the fluidized silicon deposition was 850 °C, the reaction time was 2 h, the silicon source gas was chlorosilane, the volumetric flow ratio of argon to chlorosilane gas was 1:10, and the gas velocity in the stirred fluidized bed reactor was kept at 0.015 m/s. Other steps are the same as those in Example 1.

### Comparative Example 7

The present comparative example provides a fluidized large-scale preparation method for a silicon-carbon negative electrode material. Operations of this preparation method are substantially the same as that in Example 1, and merely differ in that: the volumetric flow ratio of argon to chlorosilane gas was 1:30 in the fluidized silicon deposition reaction, the gas velocity in the stirred fluidized bed reactor was kept at 10.2 m/s; in the fluidized carbon deposition reaction, the volumetric flow ratio of argon to ethane gas was 1:45, and the gas velocity in the stirred fluidized bed reactor was kept at 1.05 m/s. Other steps are the same as those in Example 1.

### Comparative Example 8

The present comparative example provides a fluidized large-scale preparation method for a silicon-carbon negative electrode material. Operations of this preparation method are substantially the same as that in Example 1, and merely differ in that: in the fluidized silicon deposition reaction, the volumetric flow ratio of argon to chlorosilane gas was 1:27, the gas velocity in the stirred fluidized bed reactor was kept at 1.1 m/s; in the fluidized carbon deposition reaction, the volumetric flow ratio of argon to ethane gas was 1:50, and the gas velocity in the stirred fluidized bed reactor was kept at 10.1 m/s. Other steps are the same as those in Example 1.

### Detection Example

The silicon-carbon negative electrode materials prepared in Examples 1-6 and Comparative Example 1-8 were used to make negative electrode sheets which were assembled as coin half-cells. Test data are shown in detail in TABLE 1.

**TABLE 1 Test Results of Batteries**

| No. | Expansion Rate (%) | Initial Coulombic Efficiency (%) | Initial Discharge Capacity (mAh/g) | Capacity Retention after 100 Cycles (%) |
|---|---|---|---|---|
| Example 1 | 17 | 92.2 | 2035.4 | 90.4 |
| Example 2 | 19 | 91.7 | 2022.3 | 89.5 |
| Example 3 | 17 | 93.0 | 2145.8 | 91.1 |
| Example 4 | 16 | 92.4 | 2111.5 | 89.9 |
| Example 5 | 16 | 91.9 | 2067.2 | 90.1 |
| Example 6 | 18 | 92.1 | 2177.4 | 89.8 |
| Comparative Example 1 | 25 | 88.9 | 1842.2 | 83.7 |
| Comparative Example 2 | 22 | 87.3 | 1794.4 | 82.3 |
| Comparative Example 3 | 21 | 87.8 | 1844.5 | 85.4 |
| Comparative Example 4 | 22 | 86.6 | 1816.7 | 84.1 |
| Comparative Example 5 | 20 | 85.5 | 1822.4 | 83.3 |
| Comparative Example 6 | 24 | 77.5 | 1768.8 | 73.3 |
| Comparative Example 7 | 19 | 78.1 | 1693.5 | 77.9 |
| Comparative Example 8 | 19 | 77.3 | 1724.1 | 78.1 |

It can be seen from TABLE 1 that, in Examples 1-6 and Comparative Examples 1-8, the silicon-carbon negative electrode materials provided by the examples of the present disclosure have smaller expansion rates, greater initial Coulombic efficiency, higher initial discharge capacity, and higher capacity retention after 100 cycles; therefore, the materials have a better electrochemical performance and excellent cycle stability. The silicon deposition reaction and carbon deposition reaction in Examples 1-6 are both performed in the stirred fluidized bed reactor; the silicon deposition conditions and the carbon deposition conditions in Examples 2-4 have certain changes within ranges limited in the examples of the present disclosure, and have little effect on the initial discharge capacity and the capacity retention after 100 cycles of the obtained materials, wherein the changes of the silicon deposition conditions in Example 2 may cause the expansion rate of the material to become obviously high; in Examples 4-6, the rotational speeds set for the stirring paddle in the silicon deposition and carbon deposition reactors are changed, wherein the rotational speed of the stirring paddle in Example 6 is the lowest, only 10 r/min, the obtained material has the highest expansion rate, and other electrochemical performances are substantially stable. The porous carbon reaction raw material used in Comparative Example 1 has the particle size of 0-20 µm, the expansion rate of the obtained material is obviously increased, and the electrochemical performance and stability are reduced; the silicon deposition reaction and the carbon deposition reaction in Comparative Example 2 are performed in the fluidized bed reactor without a stirring function, the silicon deposition reaction in Comparative Example 3 is performed in a fluidized bed reactor without a stirring function, the carbon deposition reaction in Comparative Example 4 performed in a fluidized bed reactor without a stirring function, and it can be seen that when the stirred fluidized bed is not used in the reaction process, the capacity of the obtained material is obviously reduced, the capacity retention declines, and the expansion rate is increased. The silicon deposition conditions in Example 1 are changed in Comparative Example 5 and Comparative Example 6, and results show that the electrochemical performance and cycle stability of the materials obtained are deteriorated when the reaction conditions deviate from the range defined in the examples of the present disclosure. Comparative Example 7 and Comparative Example 8 change the fluidization conditions of the silicon deposition and carbon deposition, and significantly increase the gas velocity of fluidization, so that a fluidized state is converted during the reaction, which has the most significant negative effect on the electrochemical performance and cycle stability of the obtained material.

The above-mentioned are merely for preferred examples of the present disclosure, but are not intended to limit the present disclosure. For those skilled in the art, the present disclosure could have various modifications and changes. Any modification, equivalent replacements, improvements and so on, within the spirit and principle of the present disclosure, should be covered within the scope of protection of the present disclosure.

### INDUSTRIAL APPLICABILITY

In the fluidized large-scale preparation method for a silicon-carbon negative electrode material of the present disclosure, by performing the silicon deposition and carbon deposition in the stirred fluidized bed reactor, the preparation process is simple and reliable, and the process flow is short, which is conducive to scale-up production, and the obtained silicon-carbon negative electrode material has uniform carbon load, thereby achieving controllable adjustment of a silicon load amount and a carbon load amount. The silicon-carbon negative electrode material prepared by the fluidized large-scale preparation method for a silicon-carbon negative electrode material of the present disclosure can be applied to lithium-ion batteries and other fields that require negative electrode materials.

## Claims

1. A fluidized large-scale preparation method for a silicon-carbon negative electrode material, **characterized by** comprising: crushing a raw material, performing a fluidized silicon deposition reaction and a fluidized carbon deposition reaction, wherein the fluidized silicon deposition reaction and the fluidized carbon deposition reaction are performed in a stirred fluidized bed reactor, and conditions of the stirred fluidized bed reactor comprise: a temperature of 300-1000 °C, and a stirring speed of 1-240 r/min.

2. The fluidized large-scale preparation method for a silicon-carbon negative electrode material according to claim 1, comprising following steps:
step 1, crushing the raw material: performing crushing, grinding and sieving treatments on a porous carbon material to render a fine-grained porous carbon reaction raw material;
step 2, performing the fluidized silicon deposition reaction: performing silicon deposition on the fine-grained porous carbon reaction raw material obtained in step 1 in the stirred fluidized bed reactor into which a mixed gas of a carrier gas and a silicon source is introduced, to render a silicon-based intermediate; and
step 3, performing the fluidized carbon deposition reaction: performing carbon deposition on the silicon-based intermediate product obtained in step 2 into which a mixed gas of a carrier gas and a carbon source is introduced, to render the silicon-carbon negative electrode material.

3. The fluidized large-scale preparation method for a silicon-carbon negative electrode material according to claim 2, wherein in the step 1, the fine-grained porous carbon reaction raw material has a particle size of 0-15 µm and not 0, and a specific surface area of 500-2500 m²/g.

4. The fluidized large-scale preparation method for a silicon-carbon negative electrode material according to claim 2, wherein in the step 2, a volumetric flow ratio of the silicon source to the carrier gas is 1:1-1:25; a deposition temperature is 400-800 °C, and time is 0.5-5 h; and a flow rate of the mixed gas in the reactor is 0.001-10 m/s.

5. The fluidized large-scale preparation method for a silicon-carbon negative electrode material according to claim 2, wherein in the step 3, a volumetric flow ratio of the carbon source to the carrier gas is 1:1-1:40; a deposition temperature is 450-750 °C, and time is 1-6 h; and a flow rate of the mixed gas in the reactor is 0.001-10 m/s.

6. The fluidized large-scale preparation method for a silicon-carbon negative electrode material according to any one of claims 2-5, wherein the silicon source comprises any one or more of monosilane, disilane, hexamethyldisilane, chlorosilane and tetrafluorosilane.

7. The fluidized large-scale preparation method for a silicon-carbon negative electrode material according to any one of claims 2-5, wherein the carbon source is at least one selected from the group consisting of C1-C10 alkane, C2-C10 alkene, C2-C10 alkyne and C6-C12 aromatic hydrocarbon.

8. The fluidized large-scale preparation method for a silicon-carbon negative electrode material according to claim 7, wherein the carbon source is any one or more selected from the group consisting of methane, ethane, ethene, ethyne and propene.

9. The fluidized large-scale preparation method for a silicon-carbon negative electrode material according to any one of claims 2-5, wherein a mass ratio of porous carbon to silicon in the silicon-based intermediate obtained in step 2 is 1-800; a percentage of a mass of deposited carbon of the silicon-carbon negative electrode material obtained in step 3 to a total mass is 0-30% and not 0.

10. The fluidized large-scale preparation method for a silicon-carbon negative electrode material according to claim 1, wherein the stirred fluidized bed reactor is provided therein with a one-stage or multi-stage stirrer; and a stirring mode of the stirrer is any one or a combination of mechanical stirring, magnetic stirring, gas stirring and hydraulic stirring, preferably mechanical stirring or magnetic stirring,
wherein the stirrer using the mechanical stirring is provided therein with a stirring paddle; an installation mode of the stirring paddle comprises any one or a combination of vertical installation, horizontal installation, and inclined installation; and a structural form of the stirring paddle comprises one or more of an anchor type, a paddle type, a turbine type, a propelling type and a frame type.
